# FASCICULE DE BREVET EUROPEEN

(11) **EP 2 936 528 B1**
(45) Date de publication et mention de la délivrance du brevet: **18.01.2017**
(21) Numéro de dépôt: 13792015.3
(22) Date de dépôt: 18.11.2013
(51) Int. Cl.: H01H 3/02, H01H 9/02

(54) **SYSTÈME DE COMMANDE INCLUANT UN BOUTON D'ARRÊT D'URGENCE FIXE ET UN BOUTON D'ARRET D'URGENCE MOBILE**
STEUERUNGSSYSTEM MIT EINER STATIONÄREN NOTHALTTASTE UND EINER MOBILEN NOTHALTTASTE
CONTROL SYSTEM INCLUDING A STATIONARY EMERGENCY STOP BUTTON AND A MOBILE EMERGENCY STOP BUTTON

(30) Priorité: 20.12.2012 FR 1262400
(43) Date de publication de la demande: 28.10.2015
(73) Titulaire: Schneider Electric Industries SAS, 92500 Rueil-Malmaison (FR)
(72) Inventeur: MEFTAH, Tewfik, 38100 Grenoble (FR); CHAUVET, Francis, 16440 Mouthiers (FR); BENNI, Dominique, 16600 Mornac (FR)
(74) Mandataire: Dufresne, Thierry
(86) Numéro de dépôt international: PCT/EP2013/074028
(87) Numéro de publication internationale: WO 2014/095192

(56) Documents cités:
- EP-A1- 1 229 410
- EP-A1- 1 890 210
- EP-A2- 1 519 336
- DE-U1- 9 003 507
- GB-A- 2 198 614

## Description

### Domaine technique de l'invention

La présente invention se rapporte à un système de commande incluant un bouton d'arrêt d'urgence fixe et un bouton d'arrêt d'urgence mobile.

### Etat de la technique

Le long d'une ligne de production ou autour d'une machine, il est connu de disposer des boutons d'arrêt d'urgence à plusieurs emplacements fixes afin de pouvoir accéder rapidement à la commande du circuit électrique en cas de problème. Par ailleurs, il est également connu d'employer un bouton d'arrêt d'urgence sans-fil pour permettre à l'opérateur d'agir sur la commande du circuit électrique à tout instant, quel que soit l'endroit où il se trouve et donc sans avoir à chercher le bouton d'arrêt d'urgence fixe le plus proche. Le brevet GB2198614 propose une solution incluant des boutons d'arrêt d'urgence fixes et un bouton d'arrêt d'urgence mobile. Il en est de même du brevet EP1519336 qui décrit une solution comportant une télécommande dotée d'un bouton d'arrêt d'urgence mobile et un réceptacle fixe susceptible d'accueillir la télécommande et proposant un bouton d'arrêt d'urgence fixe. Le bouton d'arrêt d'urgence mobile et le bouton d'arrêt d'urgence fixe sont agencés pour commander le même circuit électrique. Dans cette dernière solution, lorsque la télécommande est placée sur son réceptacle et qu'elle n'est donc pas portée par l'opérateur, le bouton d'arrêt d'urgence fixe présent sur le réceptacle et le bouton d'arrêt d'urgence mobile présent sur la télécommande sont situés l'un à côté de l'autre et rendus tous les deux disponibles pour effectuer la même action. Or, dans cette situation, l'opérateur peut être amené à ne pas savoir sur quel bouton d'arrêt d'urgence il doit appuyer. La moindre hésitation peut avoir des conséquences fâcheuses.

Le but de l'invention est donc de proposer un système de commande comprenant au moins un bouton d'arrêt d'urgence fixe et un bouton d'arrêt d'urgence mobile et qui permet d'éviter à l'opérateur toute hésitation en cas d'arrêt d'urgence du circuit électrique.

### Exposé de l'invention

Ce but est atteint par un système de commande comprenant :
- un pupitre de commande fixe et un premier bouton d'arrêt d'urgence positionné sur le pupitre de commande,
- un ensemble de commande mobile comprenant un support mobile et un deuxième bouton d'arrêt d'urgence agencé sur le support mobile,
ledit système étant caractérisé en ce que :
- le pupitre de commande comporte au moins un logement,
- le support mobile peut prendre une première position dans laquelle le deuxième bouton d'arrêt d'urgence est situé à l'intérieur dudit logement de manière à être masqué à la vue d'un utilisateur, et une deuxième position dans laquelle le deuxième bouton d'arrêt d'urgence est à l'extérieur dudit logement.

Selon une particularité, le pupitre de commande comporte une première trappe escamotable fermant l'accès audit logement.

Selon une autre particularité, le pupitre de commande comporte une deuxième trappe escamotable fermant l'accès à un dégagement prévu pour recevoir le support mobile.

Selon une autre particularité, la deuxième trappe escamotable porte une interface de commande fixe.

Selon une autre particularité, le pupitre de commande comporte une ouverture latérale débouchant sur un espace de rangement pour le support mobile, ledit espace de rangement comprenant le logement agencé pour recevoir le deuxième bouton d'arrêt d'urgence.

Selon une autre particularité, le support mobile se présente sous la forme d'une tablette sur laquelle est agencé le deuxième bouton d'arrêt d'urgence et l'ensemble de commande mobile comporte une interface de commande supplémentaire agencée sur le support mobile.

Selon une autre particularité, le pupitre de commande comporte des moyens de rechargement électrique agencés pour charger une batterie de l'ensemble de commande mobile lorsque le support mobile est dans la première position.

Selon une autre particularité, le système comporte des moyens de déverrouillage du deuxième bouton d'arrêt d'urgence lorsque le support mobile est déplacé de sa deuxième position vers sa première position.

Selon une autre particularité, le système comporte des moyens de consignation du support mobile dans sa première position.

### Brève description des figures

D'autres caractéristiques et avantages vont apparaître dans la description détaillée qui suit faite en regard des dessins annexés dans lesquels :
- les figures 1A à 1C représentent un premier mode de réalisation du système de commande de l'invention,
- les figures 2A et 2B représentent un deuxième mode de réalisation du système de commande de l'invention,
- les figures 3A à 3F représentent un troisième mode de réalisation du système de commande de l'invention, la figure 3D étant une coupe transversale selon A-A du plan de la figure 3C et la figure 3F une coupe transversale selon B-B du plan de la figure 3E,
- les figures 4A et 4B représentent une variante de réalisation du troisième mode de réalisation du système de commande de l'invention,
- les figures 5A et 5B représentent un premier mode de réalisation des moyens de déverrouillage du bouton d'arrêt d'urgence mobile lorsque celui-ci est inséré dans son logement,
- les figures 6A à 6D représentent un deuxième mode de réalisation des moyens de déverrouillage du bouton d'arrêt d'urgence mobile lorsque celui-ci est inséré dans son logement,
- les figures 7A à 7D illustrent le principe de fonctionnement d'une solution de consignation de l'ensemble de commande mobile.

### Description détaillée d'au moins un mode de réalisation

Dans la suite de la description, on entend par :
- Bouton d'arrêt d'urgence fixe (AUF), un bouton d'arrêt d'urgence de type filaire agissant directement sur le circuit électrique à commander.
- Bouton d'arrêt d'urgence mobile (AUM), un bouton d'arrêt d'urgence comportant un transmetteur sans-fil apte à communiquer avec un récepteur sans-fil destiné à la commande du circuit électrique.

Selon l'invention, le système de commande comporte ainsi au moins un bouton d'arrêt d'urgence fixe AUF et au moins un bouton d'arrêt d'urgence mobile AUM. Le bouton d'arrêt d'urgence fixe AUF et le bouton d'arrêt d'urgence mobile AUM sont agencés pour commander un même circuit électrique (non représenté).

Selon l'invention, le système de commande comporte un pupitre de commande 1, 10, 100 sur lequel est positionné le bouton d'arrêt d'urgence fixe AUF.

Le système de commande comporte également un ensemble de commande mobile comportant un support mobile 2, 20, 200 sur lequel est agencé le bouton d'arrêt d'urgence mobile AUM.

Selon l'invention, en plus du bouton d'arrêt d'urgence mobile AUM, l'ensemble de commande mobile peut par exemple comporter une interface de commande 30, 300 réalisée sur le support mobile 20, 200 afin de pouvoir envoyer d'autres types de commande. Cette interface de commande peut par exemple se composer de boutons et/ou d'un écran de visualisation et/ou par exemple d'un écran tactile. Tout autre type d'interface de commande peut bien entendu être envisagé.

Selon l'invention, le support mobile 2, 20, 200 est préférentiellement alimenté par une batterie rechargeable et communique avec le pupitre de commande 1, 10, 100 à travers une liaison de communication sans-fil bidirectionnelle sécurisée (de niveau SIL au moins égal à 3). Une commande résultant par exemple d'un actionnement du bouton d'arrêt d'urgence mobile AUM ou d'une action réalisée sur l'interface de commande 30, 300 est donc envoyée automatiquement vers le pupitre de commande 1, 10, 100 à travers la liaison de communication sans-fil.

L'objectif de l'invention est de proposer une solution pour ranger le bouton d'arrêt d'urgence mobile lorsque celui-ci n'est pas utilisé par l'utilisateur, afin de le rendre inopérable.

Cet objectif est rempli en proposant sur le pupitre de commande 1, 10, 100 un logement 4, 40, 400 agencé pour recevoir le bouton d'arrêt d'urgence mobile AUM afin de le masquer à la vue de l'utilisateur.

Le support mobile 2, 20, 200 est ainsi capable de prendre une première position de rangement sur le pupitre de commande 1, 10, 100, dans laquelle le bouton d'arrêt d'urgence mobile AUM est placé dans son logement 4, 40, 400, de manière à être invisible à l'utilisateur, et une deuxième position dans laquelle le bouton d'arrêt d'urgence mobile AUM est extrait de son logement 4, 40, 400 et prêt à l'emploi.

Le pupitre de commande 1, 10, 100 comporte par exemple des moyens de charge de l'ensemble de commande mobile, coopérant avec ladite batterie lorsque le support mobile 2, 20, 200 est dans sa position de rangement. Ce rechargement est par exemple réalisé par induction ou de manière physique entre un connecteur réalisé sur le support mobile 2, 20, 200 et un connecteur présent sur le pupitre de commande 1, 10, 100.

Les boutons d'arrêt d'urgence fixe et mobile sont par exemple conforme à celui décrit dans la demande de brevet WO2012/143191. Ils sont du type comportant un poussoir de commande actionnable en translation entre une position de repos et une position actionnée, un organe d'accrochage pour maintenir le poussoir dans sa position actionnée après enfoncement et une bague B de déverrouillage distincte du poussoir de commande et actionnable en rotation pour déverrouiller le poussoir de commande, c'est-à-dire pour décrocher le poussoir de commande de sa position actionnée et lui permettre de revenir dans sa position de repos. La bague B de déverrouillage comporte par exemple plusieurs encoches E afin de faciliter sa préhension. Cette architecture est monolithique et s'avère particulièrement compacte.

Selon l'invention, le système de commande peut être réalisé selon les différents modes de réalisation détaillés ci-dessous.

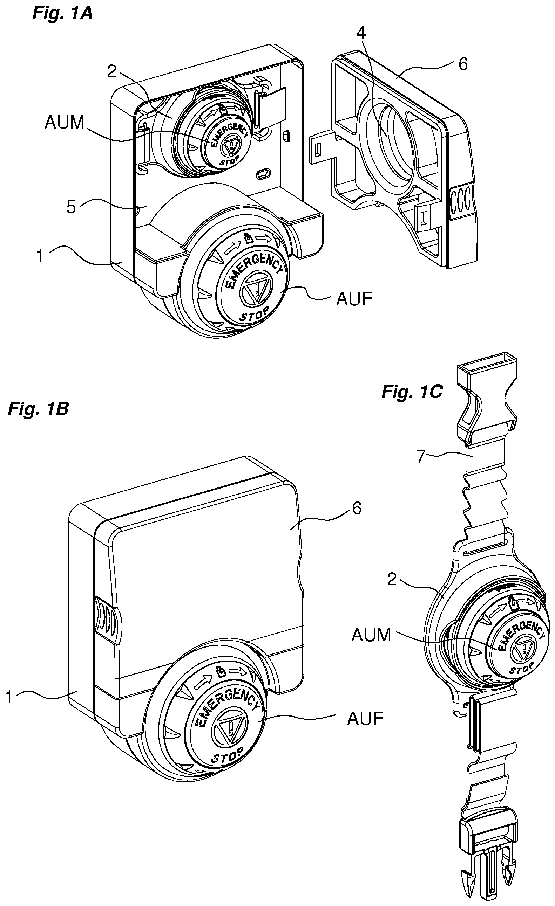

En référence aux figures 1A et 1B, le pupitre de commande 1 comporte une un compartiment de rangement 5 destiné à recevoir le support mobile 2. Le compartiment de rangement 5 est refermée par un couvercle 6 ayant une forme adaptée pour recevoir le bouton d'arrêt d'urgence mobile AUM. Une fois le couvercle 6 fermé sur le compartiment de rangement, le bouton d'arrêt d'urgence mobile AUM est invisible à l'oeil de l'utilisateur et seul le bouton d'arrêt d'urgence fixe AUF lui est accessible directement. En cas de problème, l'utilisateur présent à proximité du pupitre de commande 1 ne pourra donc qu'actionner le bouton d'arrêt d'urgence fixe AUF. Lors d'un déplacement, l'utilisateur peut à tout moment ouvrir le couvercle 6 et se saisir du support mobile 2 portant le bouton d'arrêt d'urgence mobile AUM et logé dans le compartiment 5. Tant que l'utilisateur reste dans un certain rayon autour du pupitre de commande 1, le bouton d'arrêt d'urgence mobile AUM est prêt à fonctionner. En déplacement, le support mobile 2 peut par exemple être adapté sur une sangle 7 de portage destinée à être serrée autour du corps de l'utilisateur (figure 1 C).

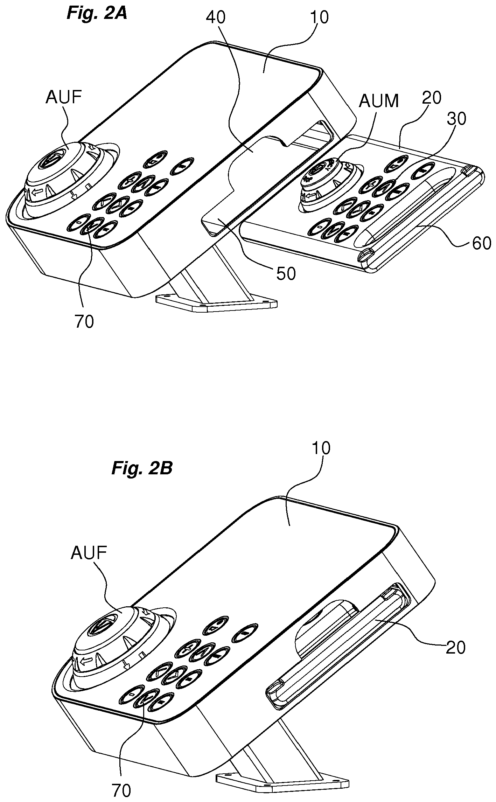

Les figures 2A et 2B montrent un deuxième mode de réalisation de l'invention. Dans ce mode de réalisation, le pupitre de commande 10, portant le bouton d'arrêt d'urgence fixe AUF, comporte une ouverture 50 latérale permettant d'accéder à un espace de rangement destiné à accueillir le support mobile 20 portant le bouton d'arrêt d'urgence mobile AUM. Cet espace de rangement comporte le logement 40 prévu pour accueillir le bouton d'arrêt d'urgence mobile AUM. Le pupitre de commande comporte par exemple une interface de commande 70, réalisée à proximité du bouton d'arrêt d'urgence fixe AUF.

Le support mobile 20 se présente par exemple sous la forme d'une tablette sur laquelle est monté le bouton d'arrêt d'urgence mobile AUM. Dans ce mode de réalisation, le support mobile 20 comporte également une interface de commande 30 positionnée à côté du bouton d'arrêt d'urgence mobile AUM. Cette interface de commande 30 est par exemple identique à celle réalisée sur le pupitre de commande 10. La tablette peut par exemple comporter une poignée 60 permettant de la manipuler et notamment de la saisir une fois insérée dans l'espace de rangement.

Le support mobile 20 est glissé en translation à travers l'ouverture 50 latérale et est enfoncé dans l'espace de rangement. L'espace de rangement est suffisamment profond pour enfoncer le support mobile 20 en totalité à l'intérieur du pupitre de commande 10. Le support mobile 20, et donc le bouton d'arrêt d'urgence mobile AUM, sont donc recouverts en totalité par le pupitre de commande 10. L'ouverture 50 latérale est dessinée de manière à épouser parfaitement la section du support mobile 20 et notamment la forme proéminente du bouton d'arrêt d'urgence mobile AUM.

Comme dans le premier mode de réalisation, lorsque le support mobile 20 est inséré dans l'espace de rangement, le bouton d'arrêt d'urgence mobile AUM se trouve entièrement masquée et n'est plus disponible à l'emploi.

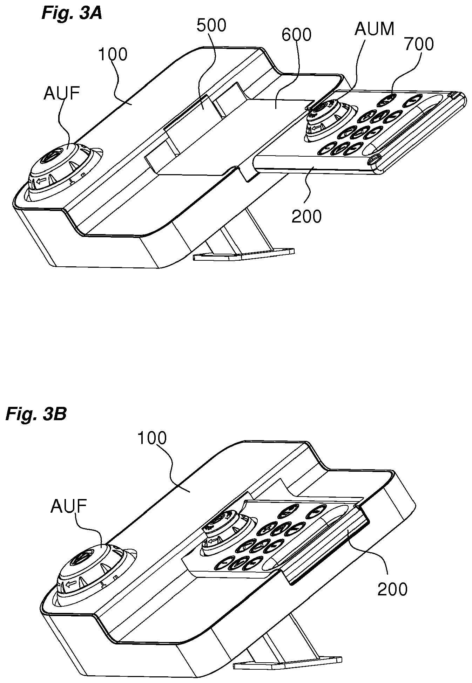

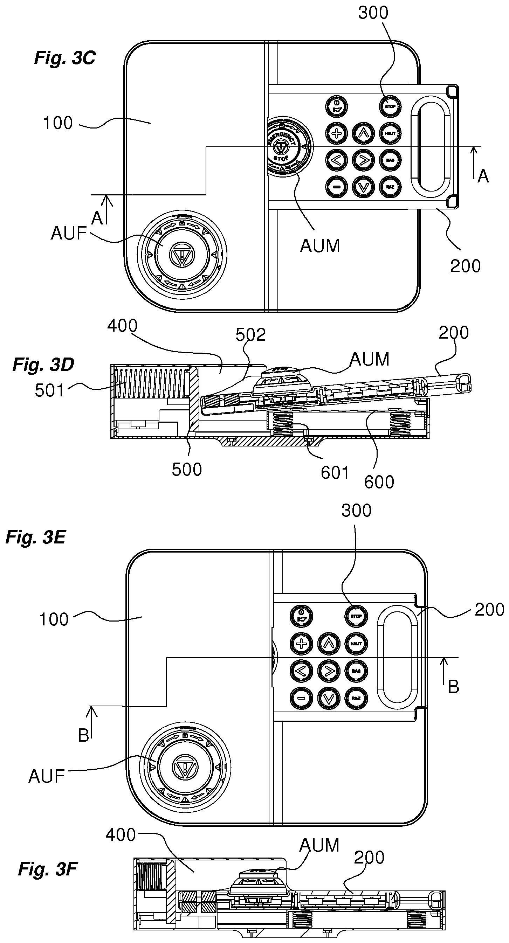

Un troisième mode de réalisation est présenté sur les figures 3A à 3F. Dans ce troisième mode de réalisation, le support mobile 200 se présente également sous la forme d'une tablette, par exemple identique à celle décrite ci-dessus pour le deuxième mode de réalisation. Elle comporte donc le bouton d'arrêt d'urgence mobile AUM, une interface de commande 300 et une poignée de préhension. Dans ce mode de réalisation, le pupitre de commande 100 comporte deux trappes 500, 600 escamotables, suivant deux plans perpendiculaires. Les deux trappes 500, 600 sont montées chacune sur un ou plusieurs ressorts 501, 601. Une première trappe 500 permet d'accéder au logement 400 destiné à recevoir le bouton d'arrêt d'urgence mobile AUM et une deuxième trappe 600 permet de dégager un espace formé sur le pupitre de commande 100 et destiné à être occupé par la tablette. Le support mobile 200 est inséré par sa tranche de manière à pousser suivant un premier plan la première trappe 500 à l'encontre de ses ressorts 501 afin de libérer l'accès au logement 400 du bouton d'arrêt d'urgence mobile AUM. La tablette est guidée par des rampes 502 jusqu'au fond dudit logement 400 de manière à insérer le bouton d'arrêt d'urgence mobile AUM dans son logement 400 puis contre la deuxième trappe 600, à l'encontre de ses ressorts 601, de manière à venir occuper l'espace libéré par la deuxième trappe 600 et se positionner sur le pupitre de commande 100. L'interface de commande 300 présente sur la tablette reste visible sur le pupitre de commande 100.

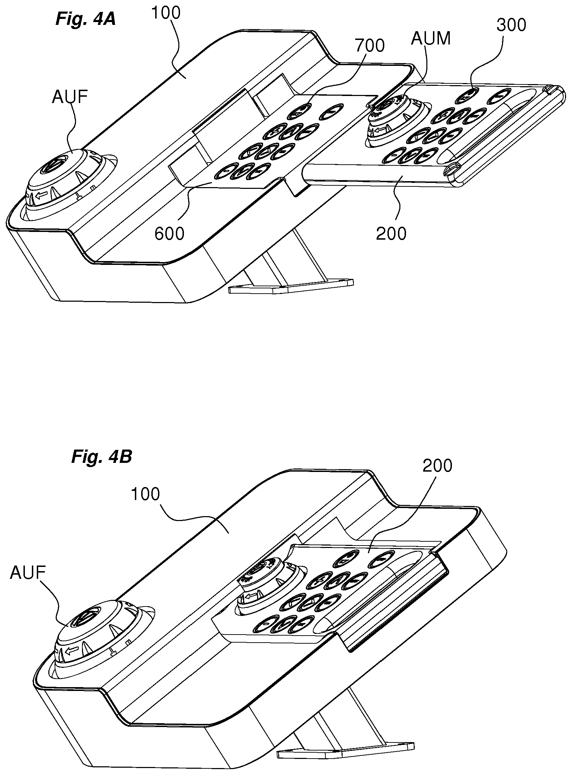

Les figures 4A et 4B représentent une variante de réalisation du système de commande du troisième mode de réalisation représenté sur les figures 3A à 3F. Selon cette variante de réalisation, une interface de commande 700 fixe est déjà présente sur le pupitre de commande 100. Cette interface de commande 700, par exemple composée de plusieurs boutons et/ou d'un écran, est réalisée directement sur la deuxième trappe 600 identique à celle décrite ci-dessus. Lorsque la tablette est positionnée sur le pupitre de commande 100, cette interface de commande 700 fixe est recouverte par l'interface de commande 300 déjà présente sur la tablette. Préférentiellement, l'interface de commande 300 présente sur la tablette et l'interface de commande 700 fixe sont identiques. On pourrait cependant imaginer une interface de commande 700 fixe comportant des fonctionnalités améliorées par rapport à celles présentes sur la tablette.

Selon l'invention, le système de commande comporte des moyens de déverrouillage du poussoir du bouton d'arrêt d'urgence mobile AUM. Ces moyens de déverrouillage sont agencés pour agir sur la bague B de déverrouillage du bouton d'arrêt d'urgence lorsque le support mobile est inséré dans son logement 40, 400.

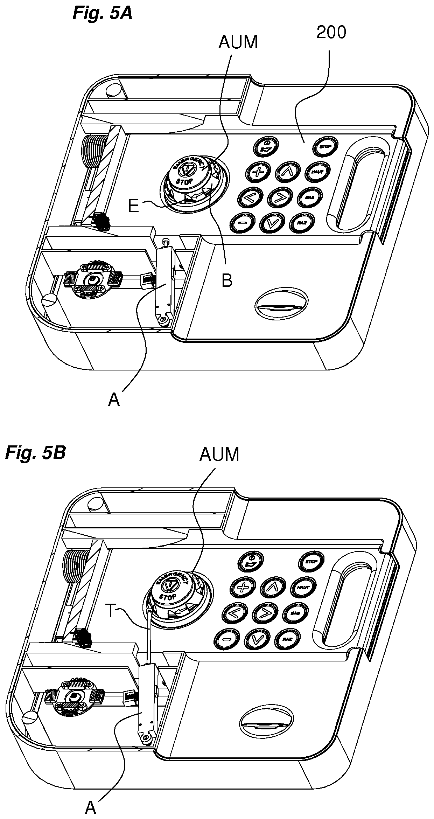

Un premier mode de réalisation de ces moyens de déverrouillage est représenté sur les figures 5A et 5B. Il est décrit pour un système de commande conforme au troisième mode de réalisation (figures 3A à 3F) ou à sa variante (figures 4A et 4B) évoqués ci-dessus. Selon ce premier mode de réalisation, ces moyens de déverrouillage comportent un actionneur A agencé à l'intérieur du pupitre de commande pour agir sur la bague B de déverrouillage du bouton d'arrêt d'urgence mobile AUM lorsque le support mobile 200 est inséré dans son logement 400. Les moyens comportent également un capteur de fin de course agencé pour détecter que la tablette est enfoncée entièrement dans son logement 400 et des moyens de détection de l'état, repos ou actionné, du bouton d'arrêt d'urgence mobile AUM. L'actionneur comporte par exemple une tige T actionnable par un électroaimant et agencée pour agir sur la bague B de déverrouillage du bouton d'arrêt d'urgence mobile pour faire passer le poussoir de sa position actionnée à sa position de repos lorsque le capteur de fin de course a détecté l'enfoncement complet du support mobile 200 dans son logement 400.

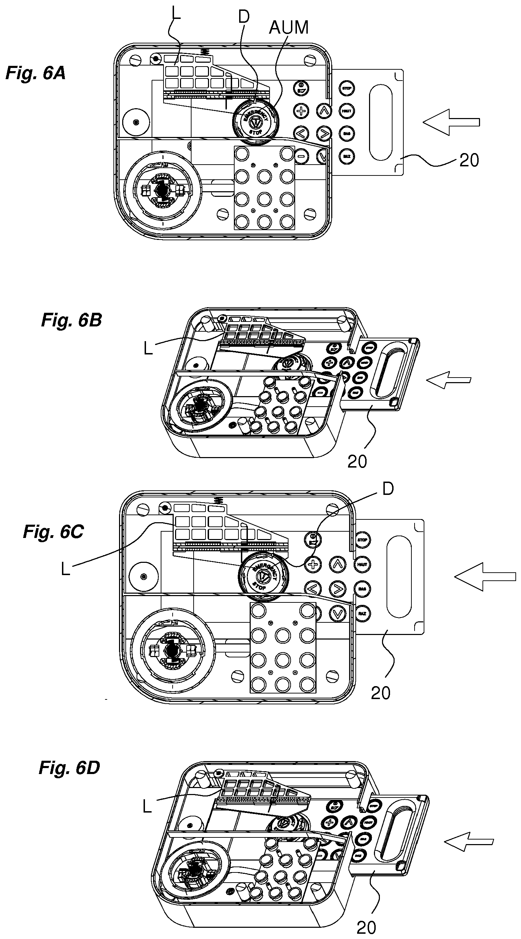

Un deuxième mode de réalisation des moyens de déverrouillage, représenté sur les figures 6A à 6D, est décrit en liaison avec le deuxième mode de réalisation du système de commande évoqué ci-dessus (figures 2A et 2B). Cette deuxième solution comporte un levier L pivotant monté à l'intérieur du pupitre de commande et comportant un doigt D apte à coopérer avec une encoche E de la bague B de déverrouillage du bouton d'arrêt d'urgence mobile. En référence à la figure 6A, si le poussoir du bouton d'arrêt d'urgence mobile AUM a été enfoncé et que le support mobile 20 est inséré à travers l'ouverture 50 pour ranger la tablette, le doigt D présent à l'extrémité du levier est agencé pour venir en contact avec une encoche E de la bague de déverrouillage afin d'entraîner la bague B en rotation lorsque le support mobile 20 est enfoncée à travers l'ouverture 50. La rotation de la bague B libère la remontée du poussoir de sa position actionnée vers sa position de repos.

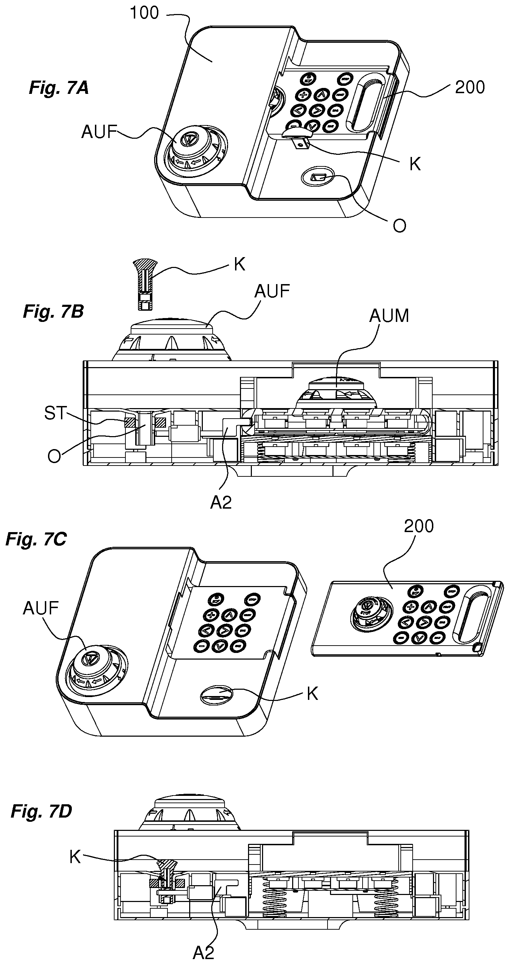

Selon l'invention, le système de commande comporte également des moyens pour consigner le support mobile 2, 20, 200 dans le pupitre de commande 1, 10, 100. Une telle solution est illustrée par les figures 7A à 7D pour un système de commande tel que défini dans le troisième mode de réalisation et sa variante décrits ci-dessus. Ces moyens comportent par exemple un mécanisme de commande et un organe de verrouillage du support mobile 200 dans sa position rangée. Cet organe de verrouillage comporte par exemple un électroaimant A2 commandé par le mécanisme de commande. Le mécanisme de commande comporte par exemple une clé K munie d'une radio-étiquette et d'un orifice O réalisée dans le pupitre de commande et dans lequel est positionné une station de lecture ST de radio-étiquette permettant une identification de la clé K introduite. Initialement, le support mobile 200 est verrouillé dans sa position rangée (figures 7A et 7B). L'introduction de la clé K adaptée permet un actionnement de l'électroaimant A2 qui déverrouille le support mobile 200, autorisant son retrait (figure 7C). La clé K introduite est alors verrouillée dans le pupitre de commande (figure 7D). Lorsque le support mobile est rangé dans le pupitre de commande, un capteur de fin de course permet de détecter cette position, entraînant à nouveau le verrouillage du support mobile 200 et la libération de la clé K qui peut alors être récupérée par l'opérateur.

## Revendications

1. Système de commande comprenant :
- un pupitre de commande (1, 10, 100) fixe et un premier bouton d'arrêt d'urgence (AUF) positionné sur le pupitre de commande,
- un ensemble de commande mobile comprenant un support mobile (2, 20, 200) et un deuxième bouton d'arrêt d'urgence (AUM) agencé sur le support mobile,
ledit système étant **caractérisé en ce que** :
- le pupitre de commande comporte au moins un logement (4, 40, 400),
- le support mobile (2, 20, 200) peut prendre une première position dans laquelle le deuxième bouton d'arrêt d'urgence (AUM) est situé à l'intérieur dudit logement (4, 40, 400) de manière à être masqué à la vue d'un utilisateur, et une deuxième position dans laquelle le deuxième bouton d'arrêt d'urgence (AUM) est à l'extérieur dudit logement.

2. Système selon la revendication 1, **caractérisé en ce que** le pupitre de commande (100) comporte une première trappe (500) escamotable fermant l'accès audit logement (400).

3. Système selon la revendication 2, **caractérisé en ce que** le pupitre de commande comporte une deuxième trappe (600) escamotable fermant l'accès à un dégagement prévu pour recevoir le support mobile (200).

4. Système selon la revendication 3, **caractérisé en ce que** la deuxième trappe escamotable porte une interface de commande fixe.

5. Système selon la revendication 1, **caractérisé en ce que** le pupitre de commande (10) comporte une ouverture (50) latérale débouchant sur un espace de rangement pour le support mobile (20), ledit espace de rangement comprenant le logement (40) agencé pour recevoir le deuxième bouton d'arrêt d'urgence (AUM).

6. Système selon l'une des revendications précédentes, **caractérisé en ce que** le support mobile (20,200) se présente sous la forme d'une tablette sur laquelle est agencé le deuxième bouton d'arrêt d'urgence (AUM) et **en ce que** l'ensemble de commande mobile comporte une interface de commande (30, 300) supplémentaire agencée sur le support mobile.

7. Système selon l'une des revendications précédentes, **caractérisé en ce que** le pupitre de commande (1, 10, 100) comporte des moyens de rechargement électrique agencés pour charger une batterie de l'ensemble de commande mobile lorsque le support mobile (2, 20, 200) est dans la première position.

8. Système selon l'une des revendications précédentes, **caractérisé en ce qu'**il comporte des moyens de déverrouillage du deuxième bouton d'arrêt d'urgence (AUM) lorsque le support mobile est déplacé de sa deuxième position vers sa première position.

9. Système selon l'une des revendications précédentes, **caractérisé en ce qu'**il comporte des moyens de consignation du support mobile dans sa première position.

## Patentansprüche

1. Steuerungssystem, umfassend:
- ein stationäres Steuerpult (1, 10, 100) und eine erste Nothalttaste (AUF), die auf dem Steuerpult angeordnet ist,
- eine mobile Steuergruppe, die einen mobilen Träger (2, 20, 200) und eine zweite Nothalttaste (AUM) aufweist, die auf dem mobilen Träger angeordnet ist,
wobei das System **dadurch gekennzeichnet, dass**
- das Steuerpult mindestens eine Aufnahme (4, 40, 400) aufweist,
- der mobile Träger (2, 20, 200) eine erste Position, in der die zweite Nothalttaste (AUM) im Innern der Aufnahme (4, 40, 400) derart angeordnet ist, um für einen Benutzer unsichtbar zu sein, und eine zweite Position einnehmen kann, in der die zweite Nothalttaste (AUM) außerhalb der Aufnahme ist.

2. System nach Anspruch 1, **dadurch gekennzeichnet, dass** das Steuerpult (100) eine erste ausklappbare Klappe (500) aufweist, die den Zugang zu der Aufnahme (400) schließt.

3. System nach Anspruch 2, **dadurch gekennzeichnet, dass** das Steuerpult eine zweite ausklappbare Klappe (600) aufweist, die den Zugang zu einem Freiraum schließt, der vorgesehen ist, um den mobile Träger (200) aufzunehmen.

4. System nach Anspruch 3, **dadurch gekennzeichnet, dass** die zweite ausklappbare Klappe () eine stationäre Steuerschnittstelle trägt.

5. System nach Anspruch 1, **dadurch gekennzeichnet, dass** das Steuerpult (10) eine seitliche Öffnung (50) aufweist, die in den Stauraum für den mobilen Träger (20) mündet, wobei der Stauraum die Aufnahme (40) aufweist, die angeordnet ist, um die zweite Nothalttaste (AUM) aufzunehmen.

6. System nach einem der vorhergehenden Ansprüche, **dadurch gekennzeichnet, dass** der mobile Träger (20, 200) die Form einer Tafel aufweist, auf der die zweite Nothalttaste (AUM) angeordnet ist, und dass die mobile Steuergruppe eine zusätzliche mobile Steuerschnittstelle (30, 300) aufweist, die auf dem mobilen Träger angeordnet ist.

7. System nach einem der vorhergehenden Ansprüche, **dadurch gekennzeichnet, dass** das Steuerpult (1, 10, 100) Mittel zum elektrischen Nachladen aufweist, die angeordnet sind, um eine Batterie der mobilen Steuergruppe zu laden, wenn der mobile Träger (2, 20, 200) in der ersten Position ist.

8. System nach einem der vorhergehenden Ansprüche, **dadurch gekennzeichnet, dass** es Mittel zum Entriegeln der zweiten Nothalttaste (AUM) aufweist, wenn der mobile Träger von seiner zweiten Position in Richtung seiner ersten Position verschoben wird.

9. System nach einem der vorhergehenden Ansprüche, **dadurch gekennzeichnet, dass** es Rücknahmemittel des mobilen Trägers in seine erste Position aufweist.

## Claims

1. A control system, comprising:
- a fixed control console (1, 10, 100) and a first emergency stop button (AUF) positioned on the control console,
- a mobile control unit comprising a mobile support (2, 20, 200) and a second emergency stop button (AUM) arranged on the mobile support,
said system being **characterized in that**:
- the control console comprises at least one cavity (4, 40, 400),
- the mobile support (2, 20, 200) can occupy a first position, in which the second emergency stop button (AUM) is located inside said cavity (4, 40, 400) so as to be concealed from the view of a user, and a second position, in which the second emergency stop button (AUM) is outside said cavity.

2. The system according to claim 1, **characterized in that** the control console (100) comprises a first retractable flap (500) closing the access to said cavity (400).

3. The system according to claim 2, **characterized in that** the control console comprises a second retractable flap (600) closing the access to a recess designed to receive the mobile support (200).

4. The system according to claim 3, **characterized in that** the second retractable flap carries a fixed control interface.

5. The system according to claim 1, **characterized in that** the control console (10) comprises a lateral opening (50) leading onto a storage space for the mobile support (20), said storage space comprising the cavity (40) arranged in order to receive the second emergency stop button (AUM).

6. The system according to one of the preceding claims, **characterized in that** the mobile support (20, 200) is in the form of a tablet on which the second emergency stop button (AUM) is arranged, and **in that** the mobile control unit comprises an additional control interface (30, 300) arranged on the mobile support.

7. The system according to one of the preceding claims, **characterized in that** the control console (1, 10, 100) comprises electrical recharging means designed to charge a battery of the mobile control unit when the mobile support (2, 20, 200) is in the first position.

8. The system according to one of the preceding claims, **characterized in that** it comprises means for unlocking the second emergency stop button (AUM) when the mobile support is moved from its second position to its first position.

9. The system according to one of the preceding claims, **characterized in that** it comprises means for retaining the mobile support in its first position.
